# EUROPEAN PATENT APPLICATION

(11) **EP 4 401 060 A1**
(43) Date of publication of application: **17.07.2024**
(21) Application number: 23151016.5
(22) Date of filing: 10.01.2023
(51) Int. Cl.: G08G 1/01, G08G 1/065, G08G 1/08, G08G 1/081, G08G 1/07

(54) **METHOD FOR CONTROL OF TRAFFIC REGULATION AGENTS OF A ROAD NETWORK**

(71) Applicant: Intergraph Corporation, Madison, AL 35758 (US)
(72) Inventor: VOGEL, Manuel Ivo, 8603 Schwerzenbach (CH)
(74) Representative: Kaminski Harmann

(57) **Abstract**

A method for control of real traffic regulation agents (A1, A2, A3) of a road network (1) comprising at least one road intersection (C1, C2, C3), the agents (A1, A2, A3) comprising traffic lights and controllable traffic signs, with automatically continuously monitoring in real time a traffic situation of the road network (1) by capturing actual traffic data using sensors (S1, S1', S2, S3) installed at the road network (1), the traffic data indicating at least actual inflow (I1, I2, I3) and outflow (O1, O2, O3, O3') for all available traffic flow directions of the road intersection (C1, C2, C3), continuously modelling the traffic situation by a computer simulation (2) comprising a digital model (3) of the road network (1) with digital traffic regulation agents (A10, A20, A30) modelling the real traffic regulation agents (A1, A2, A3) in parallel to the monitoring with the captured actual traffic data as continuous automatic input respectively update, therein simulating outflow (O10, O20, O30, O30') for all available flow directions of the road intersection (C1, C2, C3), with optimizing control of the digital traffic regulation agents (A10, A20, A30) using reinforcement learning such that the simulated outflows (O10, O20, O30, O30') are optimized and continuously adapting real-time control of the real traffic regulation agents (A1, A2, A3) according to the simulated optimized control.

## Description

The present invention relates to a method for control of traffic regulation agents of a road network.

Traffic regulation of a road network in particular in densely populated areas is a major issue, in particular preventing or managing congestions. During traffic congestion, vehicles move slowly or stop at lanes, and the queue length of the vehicles increases. Congestion that occurs in a single lane has a single-point-of-failure effect as it can also affect the traffic conditions of the other lanes at the same and neighboring intersections. Congestions contribute to a loss of time, higher levels of fuel consumption and pollution.

One type of regulation is to employ fixed-time control of traffic regulation agents such a flash lights or other adaptable traffic signs or signals. This deterministic type of solution is commonly used and quite easy to set up and maintain. However, because the timing-signal is predetermined based on historic traffic data, it is not an efficient solution when traffic situation deviates from the data that was used to calibrate it. Pre-computed fixed-time traffic signal controls are not dynamic to the different peaks and lows of traffic flow throughout a day, seasons, or even special events such as concerts.

Another solution is traffic signal control which can adapt to the current traffic condition. Such a dynamic traffic regulation is in principle known in its analogue way for a long time in form of traffic policemen which play the role of a traffic regulation agent. Its modern form are command control centers where humans monitor network congestion using live cameras and control the traffic signals remotely. Adaptive solutions are generally more expensive than fixed-time solutions due to the human effort or extra hardware installation, for example cameras, and maintenance that is required to make traffic controls responsive to real-time traffic conditions.

Also some sort of solutions are known which kind of mix the above mentioned approaches. For example, a semi-dynamic traffic agent control applies an actuated control system that uses current (or instantaneous) traffic conditions, rather than longer-term traffic conditions. For example, green flash light signals are preferably or in addition to pre-determined time intervals activated at lanes with vehicles, using a single inductive loop detector installed at a lane to detect the presence of vehicles.

Congestion is caused by or amplified by reasons or conditions such as that traffic entering an intersection is greater than the traffic leaving it (inflow greater than outflow). Further, cross-blocking occurs when vehicles cannot cross an intersection despite a green signal being activated as the respective lane of the downstream intersection has become fully occupied. As another reason, green idling occurs when no road user is present at an intersection when a green signal is activated. Also spontaneous human action or technical failure can cause unforeseen interruptions such as a pedestrian turning round halfway on a crosswalk or a broken car or an accident.

It is difficult, even for known modern automatic dynamic traffic regulation agents to take account of such conditions in an optimal way and without delay. The problem is multiplied the bigger the road network is as every lane or intersection multiplies the degrees of freedom or variables.

The object of the present invention thus is an improved method for dynamic control of traffic regulation agents of a road network.

A further object is an improved method that enables a real-time control of traffic regulation agents adaptive to a current traffic situation.

Another object is an improved method that enables optimization of the complete traffic flow of a road network based on real-time traffic data.

These objects are achieved in accordance with the invention by the characterizing features of the independent claims or by features of the dependent claims, and these solutions are also developed by features of the dependent claims.

The present invention relates to a method for control of real traffic regulation agents such as traffic lights and controllable traffic signs of a road network comprising at least one road intersection, the agents comprising. The method steps comprise automatically continuously monitoring in real time a traffic situation of the road network by capturing actual traffic data using sensors installed at the road network, the traffic data indicating at least actual inflow and outflow for all available traffic flow directions of the road intersection, and continuously modelling the traffic situation by a computer simulation comprising a digital model of the road network with digital traffic regulation agents modelling the real traffic regulation agents in parallel to the monitoring with the captured actual traffic data as continuous automatic input respectively update, therein simulating outflow for all available flow directions of the road intersection, with optimizing control of the digital traffic regulation agents using reinforcement learning, preferably deep reinforcement learning, such that the simulated outflows are optimized, preferably maximized, and continuously adapting real-time control of the real traffic regulation agents according to the simulated optimized control.

Optionally, there is determining a present or (near-)future traffic flow interruption in course of the simulation and/or based on the captured actual traffic data. Then, there is optimizing control of the agents to prevent and/or counteract the flow interruption.

Optionally, there is determining optimized control parameters for the agents in course of the control optimizing and outputting the optimized control parameters to a human controller of at least part of the real agents.

As another option, the computer simulation comprises simulation of human agent control by a human controller, in particular using a machine learning algorithm trained on past or previous human actions or behavior of control of at least part of the agents.

Optionally, the simulation enables simulation of traffic intervention by a different set of active traffic regulation agents than the present real set, such as an (additional) human traffic regulation agent, as an optimization option and puts out instructions to a user for altering the set of active agents, for instance in case traffic regulation by a human traffic regulation agent is optimal, and/or computer instructions for altering the set automatically.

In another further development of the method, the optimizing comprises determining of simulated sensor data and comparing the simulated sensor data with corresponding actual real sensor data.

In another further development, optimized travel parameters, in particular speed and/or direction, for individual traffic participants are determined in course of the simulated outflow optimization and communicated to the respective traffic participant, e.g. in form of a suggested speed or route.

As another option, at least one of the sensors is a laser scanner or stereo camera for monitoring real-time 3D-data, in particular location and/or dimension, of traffic participants.

Then, as another option, from the above mentioned monitored real-time 3D-data a movement pattern for an individual traffic participant is automatically derived and based on the movement pattern as input for the simulation, a driving and/or navigation aid information for the individual traffic participant is determined in course of the simulation and communicated to the individual traffic participant.

Optionally, the digital model models a geometry of the road network, in particular precise dimensions and/or locations of lanes and/or agents, and the geometry is taken into account in simulating the outflow.

As another option, the digital model is adaptable on-the-fly or online by machine learning based on at least part of the traffic data provided by at least part of the sensors serving as feedback control data and/or by human input of network changes, in particular an interruption of a road and/or an agent of the network.

Optionally, the traffic data enables identification of a type of monitored vehicles and the computer simulation takes into account type specific vehicle data, in particular speed related data, retrieved from a stored database.

In a further development, the simulation automatically takes into account a known future, in particular near-future network condition based on the actual time and known time stamps of the network condition for the optimizing, in particular a known time dependent recurrent traffic flow and/or a planned singular network change, in particular a construction work. Additionally or alternatively, weather condition data are taken into account for simulating, the data being provided by automatic input from sensor data as actual weather data and/or as weather forecast data from external sources.

As another option, there is optimizing control of the digital traffic regulation agents using reinforcement learning in course of the simulation such that traffic accident risk and/or energy consumption of vehicles actually using the road network is optimized, in particular minimized.

The present invention also relates to a computer program product comprising program code which is stored on a machine-readable medium, or being embodied by an electromagnetic wave comprising a program code segment, and has computer-executable instructions for the automatic execution of the computational steps of the inventive method.

The present invention with its real-time and live modelling of traffic with outflow optimization by artificial intelligence provides the advantages of a proactive approach which can nearly instantaneously react to different traffic situations and above that "foresee" evolving problems, in particular congestions, and counteract accordingly. There is a plus in traffic efficiency by reducing travel time, significant reduction of economic cost of heavy traffic and increasing the traffic handling capacity of roads. Moreover, there is risk effectiveness by less traffic meaning less accidents (cars & pedestrians) and further reduction of pollution and noise is achieved.

The method according to the invention will be described in greater detail hereinafter, purely by way of example, with reference to exemplary embodiments depicted schematically in the drawings.

More specifically, in the drawing
- Fig.1: schematically depicts a road network with sensors and controllable traffic regulation agents;
- Figs. 2a,b: schematically depict a method using a simulation for optimizing real-time control of the regulation agents;
- Fig. 3: schematically shows a further development of the control method; and
- Fig. 4: shows schematically an exemplary result of the optimized traffic regulation method.

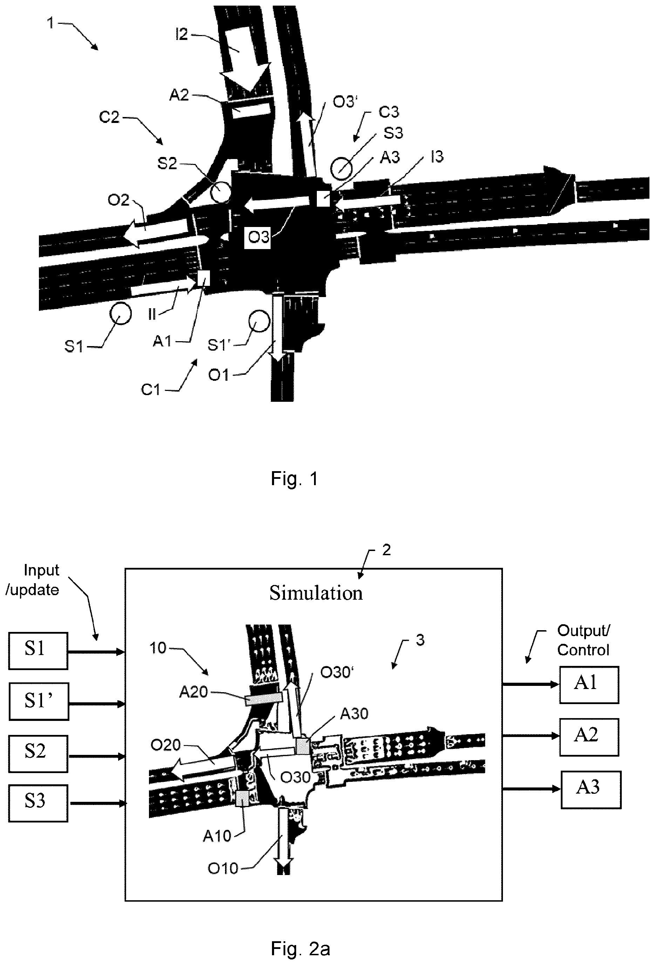

Figure 1 depicts schematically a road network 1 comprising a multitude of roads, connected by intersections or crossroads whereby in the example three crossroads C1, C2 and C2 are marked. The crossroads C1-C3 can be of different complexity, e.g. large ones with a huge number of lanes such as crossroad or small ones with only a small number of lanes.

The road network 1 comprises a plurality of controllable traffic regulation agents, wherefrom three agents A1, A2, A3 are depicted in the figure. Examples for regulation agents are traffic lights, electronic displays e.g. for depicting electronic traffic signs such as speed limit, or electro-mechanical signs which can show different signals, e.g. can simply switch between no signaling and signaling. The control agents A1-A3 are connected by wire or wirelessly to an electronic network, which can have a central processing and control unit or multiple distributed computer nodes and are therewith actively controllable in real-time, either fully automatically or by human control or interaction over the electronic network, too.

The network 1 further comprises a multitude of sensors S1, S1', S2, S3, distributed at different locations, for monitoring traffic situations in real time. Examples for sensors S1-S3' are cameras for visible or invisible light spectrum, range cameras, laser scanners for contactless 3D-coordinative measurement or surveying or contact sensors such as an inductive loop or a flash light button for pedestrians.

A sensor S1-S3 enables capturing data about traffic of the road network 1 such as presence of vehicles, number or location of traffic participants, their speed, heading or other data such as size/dimension or type of vehicle. Sensing can occur on demand, only at fixed or variable time intervals or (quasi-)continuously, e.g. by 3D-tracking of a traffic participant with one or more LIDAR-sensors. A sensor S1-S3 can be for instance situated at or nearby a road or integrated in embodiment of a traffic regulation agent A1-A3. The sensors S1-S3 are connected to said computer or communication network, too, such that the sensor data can be transferred therewith to a data processing or evaluation unit. Sensor data can be preprocessed by a respective sensor S1-S3 itself or can be sent as raw data over the data network. Further, at least some sensors S1-S3 might also be remotely controllable over the electronic network, e.g. for changing or adapting sensor parameters such as measurement rate or field of view/sensing range. Sensors S1-S3 as well as agents A1-A3 can be stationary but may also be mobile, e.g. mounted to UAVs or UGVs.

The sensors S1-S3 are chosen in such a way that the information gathered by sensors S1-S5 allows for determination of the complete traffic flow of the road network 1 (indicated in the figure by white arrows), whereby for instance sensor data of multiple sensors S1-S3, in particular of different type, can also be combined to form an information entity. That is, the sensor data indicates the inflow, exemplified in the figure by arrows I1, 12, 13, and the outflow, exemplified in the figure by arrows O1, O2, O3, O3', for all available traffic flow directions, in particular for all lanes (for sake of clarity of the figure, not all but only some in- and outflows are indicated).

As indicated in the figure, at intersection C1 sensor S1 measures the inflow I1 and sensor S1' the outflow O1, whereby first traffic agent A1 can govern outflow O1 by control of the vehicles of inflow I1, at intersection C2 sensor S2 monitors both inflow I2 and outflow O2 whereby agent A2, e.g. a multi-lane flash light panel, can regulate the according traffic lanes and at intersection C3 with traffic regulation agent A3, sensor S3 generates date for surveying inflow I3 and both outflows O3 and O3' as well.

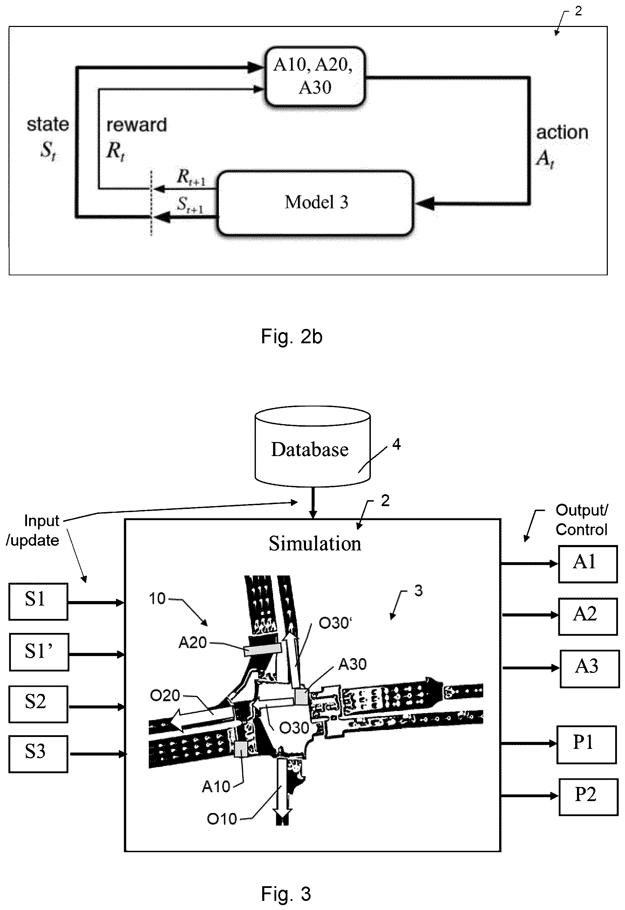

Figures 2a,b indicate schematically online usage of the real-time data generated by the sensors S1-S3 of the road network described above as input for a simulation of the road network traffic using artificial intelligence (AI).

As shown in figure 2a, the data of sensors S1-S3 are fed into a simulation 2 of a digital model 3 of the road network described with respect to figure 1. The digital model 3 models the real traffic network with its lanes and interconnections as well as the impact of the real regulation agents (A1-A3 in figure 1). The real agents A1-A3 are modelled by virtual or digital representations A10, A20, A30. In addition, the simulation 2 might model the real sensors (S1-S3 in figure 1) by virtual counterparts or also model real geometry, e.g. precise location of regulation agents or sensors, dimensions of lanes or vehicles, e.g. size of a surveyed truck. For example, a laser scanner as a sensor S1-S3 can scan an intersection C1-C3 or its nearby environment and the scans or scan items give an indication for modelling how the intersection C1-C3 resp. the environment looks like.

The simulation 2 models the actual traffic situation as described by the actual sensor data. That is, the sensor information is used to digitally represent the current traffic situation in a holistic way, describing the situation as completely as possible, based on the digital model of the road network. The simulation is done in parallel to the monitoring with the sensors, whereby continuously recent sensor data can be used to update the simulation on the flow and thereby to represent the live-situation as closely as possible.

The simulation 2 is designed to try out what is the optimal way to control traffic by machine learning. That is, the simulation "plays" with control of the digital regulation agents A10-A30 in light of the current traffic situation to optimize the simulated outflows O10-O30' which in most cases will mean to maximize simulated outflows O10-O30'. In other words, regulation of digital agents A10-A30 is varied in order to find a regulation of the digital road network 10 which allows for an optimized, in particular maximized, traffic throughput. Particularly, regulation is simulated in such a way that actual congestions are counteracted or solved or congestions which are -according to sensor data, historical data or to a result/prediction of the simulation- imminent are prevented.

The optimization result of the simulation 2 is then used to adapt the real regulation of real road network. That is, control of one or more real traffic regulation agents A1-A3 is adapted according to the simulated optimal parameters of the digital regulation counterparts A10-A30 for the current traffic situation. 4. The AI-model trained in a simulator is deployed in real-world with online learning/adaptation. Examples for adaptable and simulated parameters of agents are phases of flash lights, speed limits or closure or opening of lanes.

Implementation of control of regulation agents A1-A3 in light of the simulation results can be automatic, e.g. by a central computing unit of above mentioned computer network. However, optimized control parameters determined by the simulation 2 can also be outputted to a human operator who can control at least part of the agents A1-A3. Thus, proactive real-time recommendations to the operator can be provided on how to optimally regulate the traffic flow. The simulation 2 may also provide a real-time forecast for the case no actions or control adaptions are taken.

Thereby, as an option the simulation 2 may simulate human agent control behavior, too. Hence, the influence of human control may also be taken into account in the simulation, e.g. by a machine learning algorithm with is trained on past human control behavior. Hence, a human-in-the-loop system is considered which can provide forecasts of the implication of operator decisions to regulate traffic flow which helps to improve operator efficiency and quantitatively evaluate the quality of user decisions. As a further option, the simulator can be used for operator training prior to a real-time field-experience.

As another option, the optimizing can comprise a determination of simulated sensor data and comparing the simulated sensor data with corresponding actual real sensor data. That is for example, the validity of simulation results in form of virtual sensor data can be tested for compliance with reality by comparing them with the corresponding real sensor data. Simulation and reality thus can be closely interwoven.

In any case, the determination of improved or optimal control parameters by simulating the actual traffic situation enables a continuously adapted and optimal control of the real traffic regulation agents A1-A3 in real time, in particular within seconds or one second or less, which allows for a "delay-free" reaction and pro-active control even of highly dynamic traffic situations or complex road networks. The present method allows not only to reduce general or normal traffic resp. congestions e.g. in large road networks such as big cities, but also to optimize regulation agents such as traffic lights with AI to reduce congestion in dynamic scenarios such as lane block due to construction, unequal lane traffic, car breakdowns or stalling, different intersection profiles, and the like. Also accidents and/or natural disasters like flooding can be considered in the simulation and thus very quickly reacted to.

Optionally, the digital model 3 can be adaptable on-the-fly, e.g. by a human input of changes of the road network such as a detected or planned interruption of a road or lane or of a regulation agent A1-A3. For instance, there can be implemented a human-in the loop system in form of a human-machine interaction with the model 3 and constant update of an optimal traffic control whereby traffic control is completely or partly in the hand of the human controller. The digital model 3 may also be updated on-the-fly based on data of sensors S1-S3, e.g. overview camera images or 3D-scans. Automatic update of model 3 resp. simulation 2 can be implemented using machine learning based on at least part of the traffic data provided by at least part of the sensors, e.g. serving as feedback control data as mentioned above.

Figure 2b depicts schematically reinforcement learning which is used as machine learning of simulation 2 for finding optimal control of regulation agents A10, A20, A30.

As in principle known in the art, in a reinforcement learning model, a decision-making entity such as regulation agents A10-A30 receive feedback on its decisions. An agent's decision or action Aₜ, will alter the state Sₜ/Sₜ₊₁ of the environment or model 3 in some way. By reinforcement learning, the model 3 has the ability to provide an agent A10-A30 with a reward signal Rₜ/Rₜ₊₁. The reward signal's purpose is to provide information to the agent A10-A30 as to whether the action Aₜ just taken aligns with an agents' overall strategy or fulfils an optimal policy, in this case to optimize traffic outflows O10-O30' or seen the other way round reinforcement learning makes AI-agents A10-A30 learn the optimal policy to control the traffic at the different street intersections to minimize overall road network congestion. Additional optimization policies or criteria can be added, such as reducing traffic accident risk or minimizing energy consumption of vehicles using the road network whilst still providing optimal traffic flow output.

An agent A10-A30 may choose between at least two different possibilities, in the simplest case action or no action. Other examples have more options, e.g. a speed sign agent which can choose between multiple speed limits.

Examples of suitable reinforcement learning algorithm which are in principle known in the art are Markov Decision Process (MDP), active Adaptive Dynamic Programming (ADP) or active Temporal-Difference Learning (TD Learning) such as Q-Learning or a Deep Q-Network (DQN).

The algorithm resp. the simulation 2 is in particular designed in such a way that existing optimization policies can be evaluated by running what-if scenarios. For example, the simulation enables simulation of traffic intervention by a different set of active traffic regulation agents A10-A30 other than the present (real) set, for example an (additional) human traffic regulation agent, as an optimization option. Then, if it is found that an alternative set of active regulation agents A10-A30 is better for a current traffic situation, instructions to a user can be outputted if and how altering the set of active agents is optimal, for example if traffic regulation by a human traffic regulation agent is optimal or if an deactivated sign should be activated or an additional sign should be introduced. Additionally or alternatively, in some cases the computer network can automatically active or deactivate agents A10-A30. Traffic flow can be modelled or simulated also in order to evaluate or improve optimization policies, e.g. what are the expected benefits if the speed limit of a certain lane is increased by x%.

Figure 3, based on figure 2a, shows a further development of the method for control of traffic regulation agents. In addition to the embodiment according to figure 2a, a database 4 is added.

Database 4 is an example of additional input for the simulation 2. Hence, besides the mentioned input of sensor data, further data may be fed into the simulation, e.g. from a database 4 as depicted. The database 4 can for example provide data about historic or previous traffic situations, data about vehicles which e.g. allows to attribute technical data to a type of vehicle recognized by a sensor or actual external measurement data for above mentioned geometry of the road network, e.g. open source map data.

A database 4 can also provide external information such as actual local weather data or weather forecasts, in particular for the near future, e.g. the next hour or hours. Weather data such as temperature or air pressure can also be input by sensors installed at the road network.

Other examples of additional input, e.g. provided by a database 4, are known or planned future conditions of the road network. For instance, a known time dependent traffic flow or peak (rush hour) can be fed into the model 3. Another example is a planned demonstration, a social event with a high number of participants such as a football match or a timely planned network change such as a road construction work.

The simulation 2 can thereby also be used for city planning, for example the construction of a new bridge to be built. The simulation 2 allows for an optimization for building of the bridge allowing to understand of how the construction and final bridge influences traffic flow or dynamics and implications of different parameters such as working hours or location of construction work/bridge in the traffic flow resp. road network.

Figure 3 also indicates output of the simulation 2 in addition to control adaption of regulation agents A1-A3. In the example, travel parameters for individual traffic participants are determined in course of the simulation which allow for an optimized traffic flow and transmitted to the respective participant P1, P2. Communication between the control network and traffic participant P1, P2 can be by signalling with a control agent or over a wireless communication network. For example, a driver P1 is informed about an optimal speed or optimal route or direction via the navigation aid. Or particular in case of autonomous driving, a self-driving vehicle P2 is instructed according to the simulated parameter to reduce or increase speed or use a bypass. Such travelling aid is however not meant as control means not complying to "ordre public" or morality by enforcing an individual travel policy onto or blocking or hindering of individual traffic participants P1, P2.

Such output for traffic participants P1, P2 can also be reactive to a sensed behaviour of the respective participant. For example, with a laser scanner as a road network sensor, a vehicle P1 may be tracked and a movement pattern is derived therefrom. The movement pattern is fed into the simulation and considered in such a way, that with the background of flow optimization, a driving aid information is determined and communicated to the vehicle P1.

For instance, a driving pattern of a vehicle P1 may be considered by the AI as indicative of or typical for search for a parking slot or space. Then, live information about free parking areas in the vicinity is gathered, either by a network sensor or external sources such a parking house management system, and considering an optimal path to a free parking place, a guiding or navigation aid is communicated to the vehicle P1.

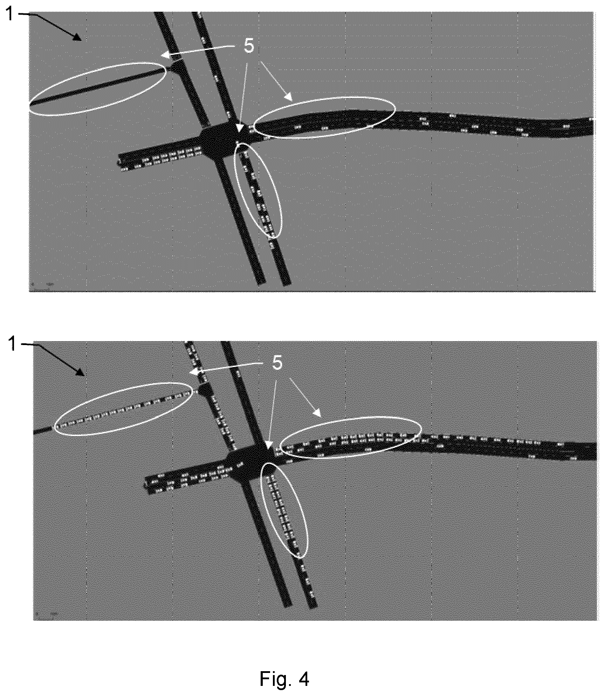

Figure 4 shows an exemplary result of the optimized traffic regulation method according to the invention. Traffic situation with adaptive regulation agent control of road network 1 according to the real-time simulation output as described above is shown in the upper part of the figure whereby the bright small squares represent vehicles. Compared therewith a traffic situation at the same point of time without the inventive control method is depicted in the lower part of the figure.

As can be seen, in particular in the marked areas or regions 5, the density of traffic or congestions are drastically reduced when the inventive method is implemented. The number of vehicles which have to stop or wait decreases heavily and the traffic outflow is improved.

Although the invention is illustrated above, partly with reference to some specific embodiments, it must be understood that numerous modifications and combinations of different features of the method can be made and that the different features can be combined with known traffic control methods.

## Claims

1. Method for control of real traffic regulation agents (A1, A2, A3) of a road network (1) comprising at least one road intersection (C1, C2, C3), the agents (A1, A2, A3) comprising traffic lights and controllable traffic signs, with
• automatically continuously monitoring in real time a traffic situation of the road network (1) by capturing actual traffic data using sensors (S1, S1', S2, S3) installed at the road network (1), the traffic data indicating at least actual inflow (I1, I2, I3) and outflow (O1, O2, O3, O3') for all available traffic flow directions of the road intersection (C1, C2, C3),
• continuously modelling the traffic situation by a computer simulation (2) comprising a digital model (3) of the road network (1) with digital traffic regulation agents (A10, A20, A30) modelling the real traffic regulation agents (A1, A2, A3) in parallel to the monitoring with the captured actual traffic data as continuous automatic input respectively update, therein simulating outflow (O10, O20, O30, O30') for all available flow directions of the road intersection (C1, C2, C3), with optimizing control of the digital traffic regulation agents (A10, A20, A30) using reinforcement learning, in particular deep reinforcement learning, such that the simulated outflows (O10, O20, O30, O30') are optimized, in particular maximized,
• continuously adapting real-time control of the real traffic regulation agents (A1, A2, A3) according to the simulated optimized control.

2. Method according to claim 1,
**characterized by**
determining a traffic flow interruption in course of the simulation (2) and/or based on the captured actual traffic data and optimizing control of the real agents (A1, A2, A3) to prevent and/or counteract the flow interruption.

3. Method according to any one of the preceding claims,
**characterized by**
determining optimized control parameters for the digital agents (A10, A20, A30) in course of the control optimizing and outputting the optimized control parameters to a human controller of at least part of the real agents (A1, A2, A3).

4. Method according to claim 3,
**characterized in that**
the computer simulation comprises simulation of human agent control, in particular using a machine learning algorithm trained on past human control of at least part of the agents.

5. Method according to any one of the preceding claims,
**characterized in that**
the simulation (2) enables simulation of traffic intervention by a different set of traffic regulation agents (A10, A20, A30) than the initial set as an optimization option and puts out instructions to a user for altering the set of active agents and/or for altering the set automatically.

6. Method according to any one of the preceding claims,
**characterized in that**
the optimizing comprises determining of simulated sensor data and comparing the simulated sensor data with corresponding actual real sensor data.

7. Method according to any one of the preceding claims,
**characterized in that**
optimized travel parameters for individual traffic participants (P1, P2) are determined in course of the simulated outflow optimization and communicated to the respective traffic participant (P1, P2).

8. Method according to any one of the preceding claims,
**characterized in that**
at least one of the sensors (S1, S1', S2, S3) is a laser scanner or stereo camera for monitoring real-time 3D-data, in particular location and/or dimension, of traffic participants (P1, P2).

9. Method according to claims 7 and 8,
**characterized in that**
from the monitored real-time 3D-data a movement pattern for an individual traffic participant (P1, P2) is automatically derived and based on the movement pattern as input for the simulation (2), a driving and/or navigation aid information for the individual traffic participant (P1, P2) is determined in course of the simulation and communicated to the individual traffic participant (P1, P2).

10. Method according to any one of the preceding claims,
**characterized in that**
the digital model (3) models a geometry of the road network (1), in particular precise dimensions and/or locations of lanes and/or agents, and the geometry is taken into account in simulating the outflow (O10, O20, O30, O30').

11. Method according to any one of the preceding claims,
**characterized in that**
the digital model (3) is adaptable on-the-fly
• by machine learning based on at least part of the traffic data provided by at least part of the sensors (S1, S1', S2', S3) and/or
• by human input of road network changes, in particular an interruption of a road and/or an agent (A1, A2, A3) of the network.

12. Method according to any one of the preceding claims,
**characterized in that**
the traffic data enables identification of a type of monitored vehicles and the computer simulation takes into account type specific vehicle data, in particular speed related data, retrieved from a stored database (4) .

13. Method according to any one of the preceding claims,
**characterized in that**
the simulation automatically takes into account
• a known future network condition based on the actual time and known time stamps of the network condition for the optimizing, and/or
• weather condition data by automatic input from sensor data as actual weather data and/or as weather forecast data.

14. Method according to any one of the preceding claims,
**characterized by**
optimizing control of the digital traffic regulation agents (A10, A20, A30) using reinforcement learning in course of the simulation such that traffic accident risk and/or energy consumption of vehicles actually using the road network is optimized.

15. A computer program product comprising program code which is stored on a machine-readable medium, or being embodied by an electromagnetic wave comprising a program code segment, and has computer-executable instructions for the automatic execution of the computational steps of the method according to any of the claims 1 to 14.
